# EUROPEAN PATENT APPLICATION

(11) **EP 2 546 697 A2**
(43) Date of publication of application: **16.01.2013**
(21) Application number: 11753570.8
(22) Date of filing: 07.03.2011
(51) Int. Cl.: G03F 7/004, G03F 7/039, H01B 3/38, C08J 5/18

(54) **PHOTOSENSITIVE ORGANIC INSULATION COMPOSITION FOR AN OLED DEVICE**

(30) Priority: 23.02.2011 KR 20110015963; 11.03.2010 KR 20100021946
(71) Applicant: LG Chem, Ltd., Seoul 150-721 (KR)
(72) Inventor: KIM, Sang Woo, Daejeon 305-380 (KR); AHN, Kyoung Ho, Daejeon 300-717 (KR); KIM, Kyung Jun, Daejeon 305-350 (KR); SHIN, Se Jin, Daejeon 305-340 (KR); JEONG, Hye Won, Yuseong-gu, Daejon, 305-380 (KR); PARK, Chan Hyo, Daejeon 305-340 (KR); JO, Jung Ho, Daejeon 305-791 (KR); KIM, Yu Na, 305-380 republic of Korea (KR)
(74) Representative: Goddar, Heinz J.
(86) International application number: PCT/KR2011/001562
(87) International publication number: WO 2011/111965

(57) **Abstract**

Polyimide or a precursor thereof expressed by Chemical Formula 1 or 2 and a photosensitive organic insulator composition having the same are disclosed. The polyimide or the precursor thereof is prepared from diamine including polyalkyleneoxide.

The use of the photosensitive organic insulator composition can allow for low temperature curing and shorten a curing time, form a low taper angle, and implement a high sensitivity and high residual film. Also, since the photosensitive organic insulator composition, as a positive photosensitive composition, has excellent solubility with respect to an alkali solution of an exposed portion, the generation of impurity can be minimized.

## Description

### BACKGROUND OF THE INVENTION

### Field of the Invention

The present invention relates to a photosensitive organic insulator composition for an organic light emitting diode (OLED) device.

### Related Art

In an organic light emitting diode (OLED) device, a polyimide (PI) insulating layer is formed on an area, excluding an area on which an organic emission material for an OLED device is to be deposited to act as pixels, to define the shape of pixels, and allows the respective pixels to be electrically independently driven.

Polyimide, polymer having a hetero imide ring in a backbone, is prepared by polycondensing tetracarboxylic acid and diamine.

Polyimide has excellent light transmittance, mechanical qualities, thermal characteristics and excellent adhesive strength with a substrate, and as such, polyimide has commercial importance. Polyimide has extensively employed to replace metal, glass, or the like, in various sectors, such as electrics, electronics, vehicles, airplanes, semiconductor, and the like.

In particular, polyimide has such excellent thermal and mechanical properties as to be used as a material of a surface protection layer or insulating layer of a semiconductor element. Since most of polyimide has a low solubility, in general, a polyimide precursor solution is obtained, coated on a substrate, such as glass substrate, or the like, and then cured through a thermal treatment so as to be fabricated. A commercial polyimide product is supplied in a state of being a polyimide precursor solution or a polyimide film. In the semiconductor element field, the polyimide product is supplied in the state of being a polyimide precursor solution.

A photosensitive organic insulator composition is advantageous in that it has reliable light sensitivity and low temperature during and a short curing time and can provide an insulating layer forming a low taper angle. Also, it can implement a high residual film without a residual at an edge thereof, and preferably, an exposed portion is dissolved in an alkali solution to minimize a generation of a impurity. The selection of a synthetic monomer for preparing polyimide or a polyimide precursor used as a photosensitive resin of an organic insulator composition is significant.

### Summary of the Invention

Thus, inventors of the present invention have repeatedly conducted in-depth researches and various experiments to discover that low temperature curing and a low taper angle can be implemented by using polyimide or a precursor thereof, which is prepared by using diamine containing polyalkyleneoxide as a synthetic monomer, as an organic insulator composition and to develop a photosensitive organic insulator composition having excellent light transmittance and light sensitivity and exhibiting excellent adhesion with a substrate.

It is, therefore, an object of the present invention to provide a photosensitive organic insulator composition for an organic light emitting diode (OLED) device allowing for an implementation of low temperature curing and a formation of a low taper angle.

Another object of the present invention is to provide a photosensitive organic insulator composition having excellent film characteristics ensuring a high level of adhesion and preventing a generation of cracks.

To achieve the above objects, there is provided a photosensitive organic insulator composition comprising 1 to 50 weight parts of a photo active compound over 100 weight parts of polyimide or a precursor thereof expressed by Chemical Formula 1 or 2 shown below:

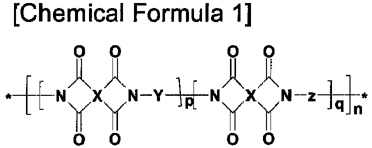

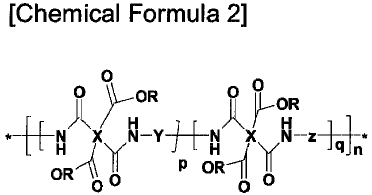

Here, X is a quadrivalent organic group, Y is a bivalent organic group, and Z is derived from a diamine compound expressed by Chemical Formula 3 shown below:

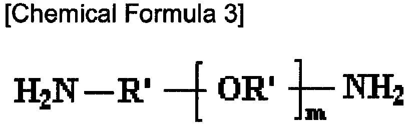

Here, m is an integer ranging from 2 to 21, and R' is an alkylene group having 2 to 6 carbon atoms.

Also, 0≤p<1, 0<q≤1, p+q=1;
n is an integer ranging from 2 to 500;
R is selected from the group consisting of hydrogen, an alkyl group, and a silyl alkyl group.

Preferably, Z in Chemical Formula 1 is derived from a diamine compound expressed by Chemical Formula 4 shown below:

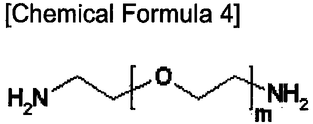

Here, m is an integer ranging from 2 to 21.

Preferably, m in Chemical Formula 4 is an integer ranging from 2 to 7.

A substituent X in Chemical Formula 1 or 2 may be one or more selected from the group consisting of quadrivalent organic groups shown below:

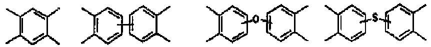

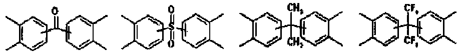

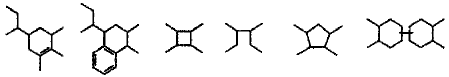

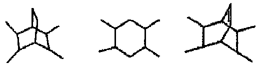

Also, a substituent Y in Chemical Formula 1 or 2 may be one or more selected from the group consisting of bivalent organic groups shown below:

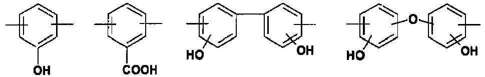

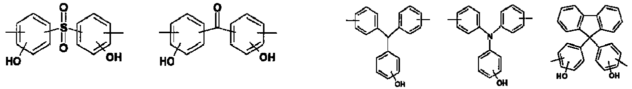

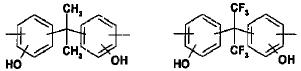

Also, the substituent Y in Chemical Formula 1 or 2 may be a bivalent organic group derived from one or more diamine compounds selected from the group consisting of a plurality of diamine compounds shown below:

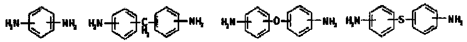

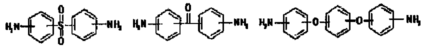

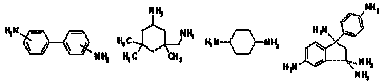

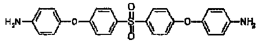

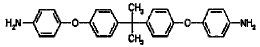

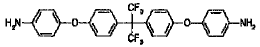

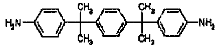

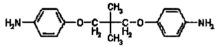

Meanwhile, the photo active compound may be one or more selected from the group consisting of compounds shown below:

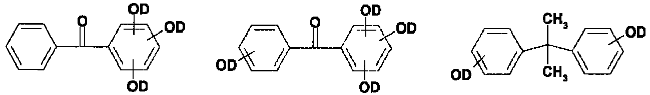

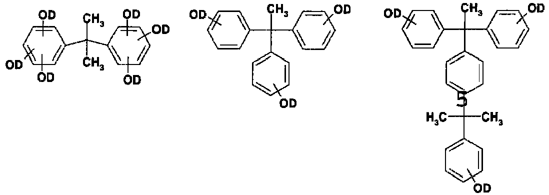

Here, D may be one or more selected from among organic groups expressed by chemical formulas shown below and a hydrogen atom (H):

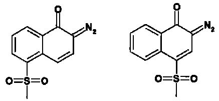

Meanwhile, the photosensitive organic insulator composition may contain 0.1 to 30 weight parts of one or more additives selected from the group consisting of a dissolution speed regulator, a sensitizer, an adhesion promoter, and a surfactant over 100 weight parts of the polyimide or the precursor thereof.

Preferably, the photosensitive organic insulator composition may contain 40 to 97 weight part of one or more solvents selected from the group consisting of N-methyl-2-pyrrolidone, N,N-dimethylformamide, N,N-dmiethylacetamide, dimethylsulfoxide, N,N-diethylacetamide, γ-butyrolactone, γ-valerolactone, m-cresol, ethyleneglycol monomethylether, ethyleneglycol monomethylether acetate, ethyleneglycol monoethylether, ethyleneglycol monoethylether acetate, ethyleneglycol monobutylether, ethyleneglycol monobutylether acetate, propyleneglycol monomethylether, propyleneglycol monomethylether acetate, propyleneglycol monoethylether, propyleneglycol monoethylether acetate, propyleneglycol monopropylether, propyleneglycol monopropylether acetate, propyleneglycol monobutylether, propyleneglycol monobutylether acetate, propyleneglycol dimethylether, propyleneglycol diethylether, propyleneglycol dipropyltylether, propyleneglycol dibutylether, ethyl lactate, butyl lactate, cyclohexanone, and cyclopentanone, over 100 weight parts of the composition.

According to exemplary embodiments of the present invention, a photosensitive organic insulator composition including polyimide or a precursor thereof has a high level of adhesion with a substrate in a final device fabrication process, does not have a residue at a pattern edge portion, and implement a low taper angle even at a low temperature curing process.

### Brief Description of the Drawings

The above and other objects and features of the present invention will become apparent from the following description of preferred embodiments given in conjunction with the accompanying drawings, in which:
FIGS. 1 and 2 show morphologies of insulating layers in an organic light emitting diode (OLED) device employing a photosensitive organic insulator composition including resins fabricated in Embodiment 1 and Embodiment 2, respectively.
FIGS. 3 and 4 show morphologies of insulating layers in an OLED device employing a photosensitive organic insulator composition including resins fabricated in Comparative Example 1 and Comparative Example 2, respectively.

### Detailed Description of the Embodiments

The present invention is directed to a photosensitive organic insulator composition including polyimide or a precursor thereof.

A photosensitive organic insulator composition according to an exemplary embodiment of the present invention includes polyimide or a precursor thereof prepared by using diamine, including polyalkyleneoxide, as a synthetic monomer, and a photo active compound which is able to generate acid by light, and is fabricated by adding an adhesion promoter and a surfactant as necessary.

The polyimide or the precursor thereof used as a base resin in the present exemplary embodiment is a polymer expressed by chemical formula 1 or 2 shown below:

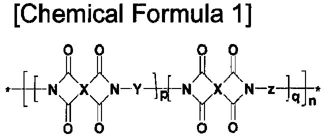

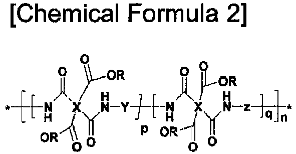

Here, X is a quadrivalent organic group, Y is a bivalent organic group, and Z is derived from a diamine compound expressed by Chemical Formula 3 shown below:

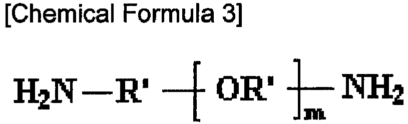

Here, m is an integer ranging from 2 to 21, and R' is an alkylene group having 2 to 6 carbon atoms.

Also, 0≤p<1, 0<q≤1, p+q=1;
n is an integer ranging from 2 to 500;
R is selected from the group consisting of hydrogen, an alkyl group, and a silyl alkyl group.

The polyimide or the precursor thereof having a repeating unit of Chemical Formula 1 or 2 is prepared by reacting tetracarboxyl dianhyride, an acid component, and diamine under the presence of an organic solvent.

In an exemplary embodiment of the present invention, diamine containing polyalkyleneoxide ([-OR']ₘ) is used as a diamine compound.

Of the polyalkyleneoxide, R' may be an alkylene group having two to six carbon atoms. Preferably, R' is polyethyleneoxide as an ethylene group.

Thus, preferably, a substituent Z of the polyimide or the precursor thereof expressed by Chemical Formula 1 or 2 is defined as a 'bivalent organic group containing polyethyleneoxide' derived from a diamine compound expressed by Chemical Formula 4 shown below:

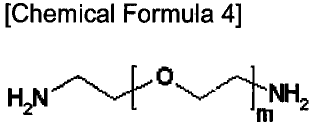

Here, m is an integer ranging from 2 to 21.

The polyimide or the precursor thereof containing the substituent Z is a photosensitive organic insulator composition, and when it is used as an insulating layer of an organic light emitting diode (OLED) device, the insulating layer can have excellent adhesion with a substrate and implements a low taper angle even at a low temperature curing process.

A substituent X of the polyimide or the precursor thereof expressed by Chemical Formula 1 or 2 may be one or two or more of quadrivalent organic groups derived from tetracarboxyl dianhydride used for polyimide or a precursor thereof which are expressed by chemical formulas shown below:

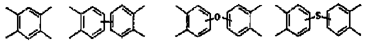

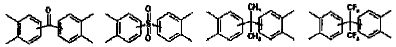

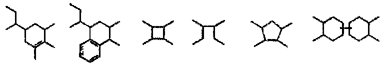

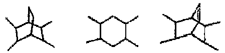

In the present exemplary embodiment, tetracarboxyl dianhydride including one or more quadrivalent organic groups selected from among quadrivalent organic groups expressed by the chemical formulas is condensed with diamine expressed by Chemical Formula 3 shown below:

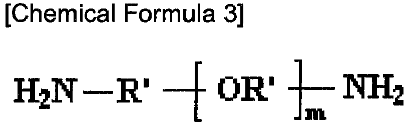

Here, m is an integer ranging from 2 to 21, and R' is an alkyl group having two to six carbon atoms.

Also, in the present exemplary embodiment, in order to provide photosensitivity to polyimide or a precursor thereof, polyimide or a precursor thereof is prepared by using diamine including one or more selected from the bivalent organic groups expressed by chemical formulas shown below, besides diamine expressed by Chemical Formula 3, as a synthetic monomer.

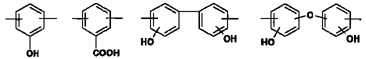

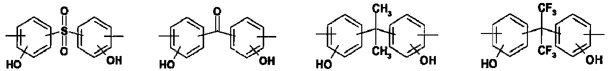

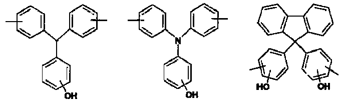

The bivalent organic groups expressed by the above chemical formulas include phenolic hydroxyl group or carboxyl group to provide alkali solubility to the polyimide or the precursor thereof according to the present exemplary embodiment.

A substituent Y of the polyimide or the precursor thereof expressed by Chemical Formula 1 or 2 may be one or more selected from the bivalent organic groups.

Also, in the present exemplary embodiment, in order to control the photosensitivity of polyimide or a precursor thereof, one or more selected from the group consisting of diamine groups expressed by chemical formulas shown below, as a synthetic monomer.

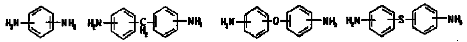

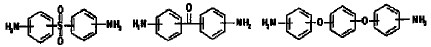

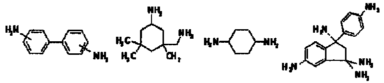

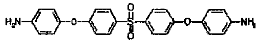

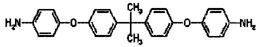

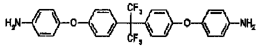

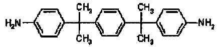

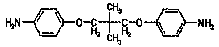

In the present exemplary embodiment, polyimide or a precursor thereof which has a weight average molecular weight of 2,000 to 200,000 may be used. If the weight average molecular weight is too low, film characteristics would deteriorate, and if it is too high, the solubility of a developer would be degraded.

The polyimide or the precursor thereof is prepared by reacting tetracarboxyl dianhydride and a diamine compound expressed by Chemical Formula 3 under the presence of an organic solvent.

As the organic solvent used for preparing the polyimide or the precursor thereof, one or more selected from the group consisting of N-methyl-2-pyrrolidone, N,N-dimethylformamide, N,N-dmiethylacetamide, dimethylsulfoxide, N,N-diethylacetamide, γ-butyrolactone, ethylcellosolve, butylcellosolve, diethyleneglycol, methylethylether, diethyleneglycol, dimethylether, diethyleneglycol, diethylether, dipropyleneglycol, dimethylether, methyl-3-methoxy propionate, ethyl 3-ethoxy propionate, propyleneglycol methylether propionate, dipropyleneglycol dimethylether, cyclohexanone, and propyleneglycolmonomethyletheracetate.

A photosensitive polyimide resin composition according to the present exemplary embodiment is prepared by adding a photo active compound (PAC) to the thusly prepared polyimide or the precursor thereof, and adding a dissolution speed regulator, a sensitizer, an adhesion promoter, and a surfactant, as necessary.

The respective additives may be used within the range of 0.1 to 30 weight parts over 100 weight parts of the polyimide or the precursor thereof.

As the photo active compound used in the present exemplary embodiment, one or a combination of two or more selected from the group consisting compounds expressed by chemical formulas shown below may be used.

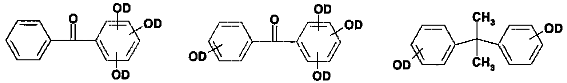

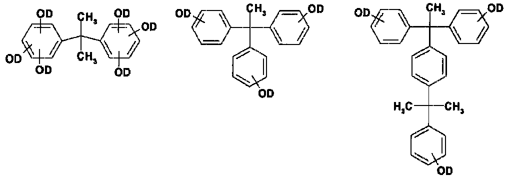

Here, D may be any one selected from among organic groups expressed by chemical formulas shown below and a hydrogen atom (-H):

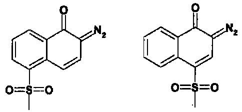

Preferably, the photo active compound is used by 1 to 50 weight parts over 100 weight parts of the polyimide or the precursor thereof.

A solvent used for the photosensitive organic insulator composition according to the present exemplary embodiment is not particularly limited so long as it can dissolve the polyimide or the precursor thereof. For example, as the solvent, one or more selected from the group consisting of N-methyl-2-pyrrolidone, N,N-dimethylformamide, N,N-dmiethylacetamide, dimethylsulfoxide, N,N-diethylacetamide, γ-butyrolactone, γ-valerolactone, m-cresol, ethyleneglycol monomethylether, ethyleneglycol monomethylether acetate, ethyleneglycol monoethylether, ethyleneglycol monoethylether acetate, ethyleneglycol monobutylether, ethyleneglycol monobutylether acetate, propyleneglycol monomethylether, propyleneglycol monomethylether acetate, propyleneglycol monoethylether, propyleneglycol monoethylether acetate, propyleneglycol monopropylether, propyleneglycol monopropylether acetate, propyleneglycol monobutylether, propyleneglycol monobutylether acetate, propyleneglycol dimethylether, propyleneglycol diethylether, propyleneglycol dipropyltylether, propyleneglycol dibutylether, ethyl lactate, butyl lactate, cyclohexanone, and cyclopentanone may be used.

Preferably, the photosensitive organic insulator composition according to the present exemplary embodiment may include a 40 to 97 weight parts of a solvent over 100 weight parts of the composition. If the solvent is contained to be less than 40 weight parts, the composition would have a high viscosity of more than necessary, failing to obtain a smooth surface when coated, failing to implement a desired thickness, and failing to form an even mixture in making a liquid to result in difficulty in implementing physical properties for forming fine patterns. If the solvent is contained to exceed 97 weight parts, an adhesion with a substrate would deteriorate and it is difficult to obtain uniform coating properties and a desired film thickness.

The photosensitive organic insulator composition according to the present exemplary embodiment having the foregoing composition is applied to a base such as a glass substrate, or the like, by using a general method such as spin coating, slit spin coating, roll coating, die coating, curtain coating, or the like, and subject to an exposing and developing process to form a photosensitive film. The exposing and developing process is not particularly limited and a general method used to form a photosensitive layer using a general photosensitive organic insulator composition may be used.

In the exposing process, electromagnetic waves, visible light from ultraviolet ray, electron beam, X-ray, laser light, and the like, may be irradiated as a light source. Also, in irradiating the light source, a known means such as a high pressure mercury lamp, an xenon flash lamp, a carbon arc lamp, a halogen lamp, a cold cathode fluorescent lamp (CCFL) for a copier, an LED, a semiconductor layer, and the like, may be used.

In the developing process, an exposed area of the photosensitive film which has subject to the exposing process is removed by using a developer to form patterns. In this case, an alkaline solution such as a hydroxide of alkaline metal or alkaline earth metal, a carbonate, hydrogen carbonate, or ammonia water 4^{th}-grade ammonium salt may be used as the developer. In this case, an ammonia 4^{th}-grade ammonium aqueous solution such as a tetramethyl ammonium aqueous solution is particularly preferred.

As for the overall process, the photosensitive organic insulator composition is spin-coated on a glass or silicon wafer substrate and then pre-annealed for one to two minutes at about 110°C to 145°C to form a film. The film is exposed through a pattern-formed photo mask, and the exposed portion is developed by using an alkaline aqueous solution and then cleansed with deionized water. Thereafter, the resultant film is post-heated for about 30 minutes to two hours at a temperature ranging from 200°C to 350°C to obtain patterns.

The present invention will be described in more detail based on embodiments as follows; however, the present invention is not limited thereto.

### Synthesis Example 1 - (Preparation of 3,3',4,4'-diphenyl ether tetracarboxylic acid dichloride)

300 ml of anhydrous methyl alcohol was added to 31.0g (0.1 mole) of 3,3',4,4'-diphenyl ether tetracarboxylic acid dianhyride, which was then refluxed and stirred for five hours at 80°C so as to be reacted. The residual solvent was dried under a high temperature and reduced pressure to obtain 37.4 g (yield rate of 100%) of 3,3',4,4'-diphenyl ether tetracarboxylic acid dimethylester. 35.4g (0.3 mole) of thionylchloride was applied drop-wise to the obtained 37.4 g (0.1 mole) of 3,3',4,4'-diphenyl ether tetracarboxylic acid dimethylester, to which N,N-dimethylformamide of a catalyst amount was added, reacted at 90°C for three hours, and then cooled to room temperature. The residual thionylchloride was removed at a reduced pressure to obtain 41.0 g (yield rate of 100%) of 3,3',4,4'-diphenyl ether tetracarboxylic acid dichloride.

### Embodiment 1 - (Preparation of polymer P-1)

24.6 g (60 mmole) of the prepared 3,3',4,4'-diphenyl ether tetracarboxylic acid dichloride was slowly applied dropwise to 150 ml of N-methyl-2-pyrrolydone with 15.4 g (42 mmole) of 2,2-bis(3-amino-4-hydroxyphenyl)-hexafluoropropane, 2.7 g (18 mmole) of 1,2-bis(2-aminoethoxy)ethane, and 10.65 g of pyridine dissolved therein, at 0°C under a nitrogen atmosphere, the temperature was slowly increased to room temperature and then the resultant material was stirred five hours. Thereafter, the reactant was slowly applied dropwise to 2L of water to generate a precipitate, the generated precipitate was filtered out, cleansed with water three times, and then dried at a reduced pressure to obtain 32.5 g of polyamic acid methylester (P-1). The weight average molecular weight of the obtained polymer was 28,000.

### Embodiment 2 - (Preparation of Polymer P-2)

A polymer P-2 was obtained in the same manner except for the addition of 13.2 g (36 mmole) of 2,2-bis(3-amino-4-hydroxyphenyl)-hexafluoropropane, 1.7 g (12 mmole) of 1,2-bis(2-aminoethoxy)ethane, and 2.4 g (12 mmole) of 4-oxy dianiline, instead of 15.4 g (42 mmole) of 2,2-bis(3-amino-4-hydroxyphenyl)-hexafluoropropane and 2.7 g (18 mmole) of 1,2-bis(2-aminoethoxy)ethane in Embodiment 1. The weight average molecular weight of the obtained polymer P-2 was 25,000.

### Comparative Example 1 - (Preparation of polymer P-3)

A polyamic acid methylester (P-3) was obtained in the same manner except for the use of 22.0 g (60 mmole) of 2,2-bis(3-amino-4-hydroxyphenyl)-hexafluoropropane as a total amount, instead of 15.4 g (42 mmole) of 2,2-bis(3-amino-4-hydroxyphenyl)-hexafluoropropane and 2.7 g (18 mmole) of 1,2-bis(2-aminoethoxy)ethane in Embodiment 1. The weight average molecular weight of the obtained polymer was 29,500.

### Comparative Example 2 - (Preparation of polymer P-4)

A polyimide (P-4) was obtained in the same manner except for the addition of 17.6 g (48 mmole) of 2,2-bis(3-amino-4-hydroxyphenyl)-hexafluoropropane and 2.4 g (12 mmole) of 4-oxy dianiline, instead of 13.2 g (36 mmole) of 2,2-bis(3-amino-4-hydroxyphenyl)-hexafluoropropane and 1.8 g (12 mmole) of 1,2-bis(2-aminoethoxy)ethane in Embodiment 2. The weight average molecular weight of the obtained polymer was 23,000.

### Preparation of photosensitive organic insulator composition and evaluation of its characteristics

3 g of the thusly obtained polyimide precursors (P-1 and P-3) or the polyimides (P-2 and P-4) and 1.0 g of diazonaphthoquinone ester compound (TPPA 320: OH or OD is selectively given according to the ratio of OD/(OD+OH)=2/3) as a photo active compound were applied to a solvent of 8 g of N-methyl-2-pyrrolydone. The resultant material was stirred at room temperature for one hour and then filtered by using a filter with fine pores having a diameter of 1 µm to prepare a photosensitive organic insulator composition.

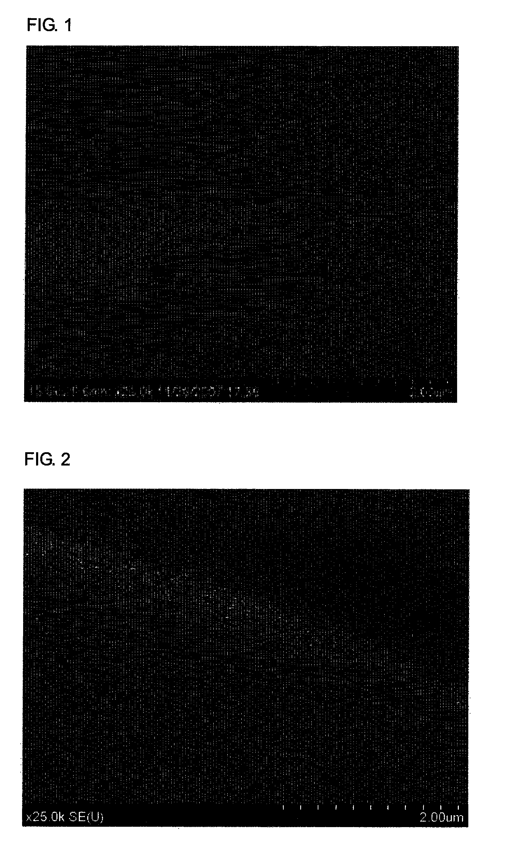

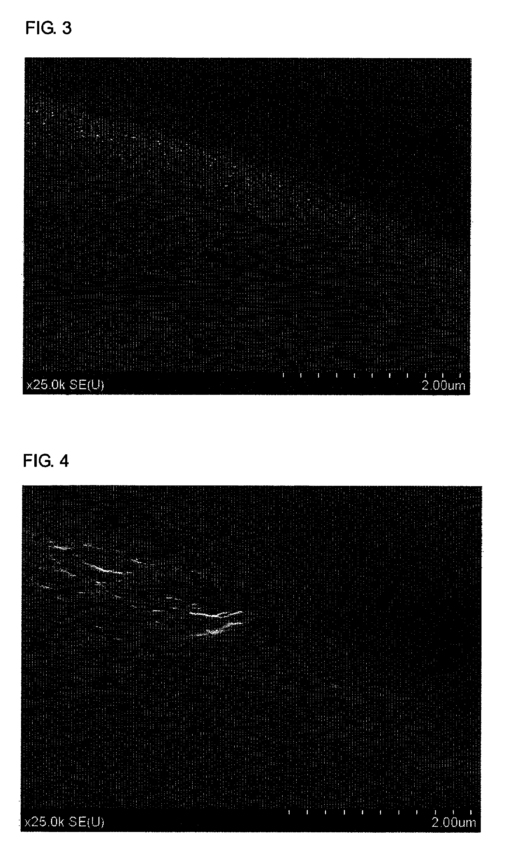

The physical properties of the thusly prepared photosensitive organic insulator composition were measured in the following manner, and the results were shown in [Table 1] and FIGS. 1 to 4.

### 1. Taper angle photographing

A taper angle was measured through a section SEM image of a patterned resist, and the thickness and a residual film were measured by using a surface profiler with respect to the resist before and after a developing process.

### 2. Evaluation of sensitivity

In order to evaluate the sensitivity, the amount of light exposure, by which the exposed portion was completely melt by the developer, was measured through a stepper and an aligner.

### 3. Evaluation of residue and adhesion

In order to evaluate a residue and adhesion, the shape of patterns remaining after a patterning process was performed was observed.

**[Table 1]**

| | Thickness (um) | Sensitivity (mJ) | Taper Angle | Residue | Adhesion | Residual film (%) | Curing Temperatu re (°C) | Curing duration (Min.) |
|---|---|---|---|---|---|---|---|---|
| Embodioment 1 | 1.8 | 28 | 24 | Good | Good | 85 | 230 | 30 |
| Embodioment 2 | 1.8 | 35 | 28 | Good | Good | 90 | 230 | 30 |
| Comparative Example 1 | 1.7 | 70 | 64 | Poor | Not good | 90 | 280 | 60 |
| Comparative Example 2 | 1.8 | 60 | 47 | Good | Not good | 85 | 280 | 60 |

## Claims

1. A photosensitive organic insulator composition comprising 1 to 50 weight parts of a photo active compound over 100 weight parts of polyimide or a precursor thereof expressed by Chemical Formula 1 or 2 shown below: 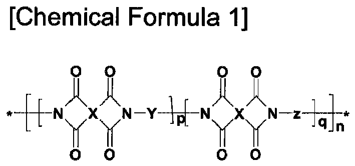 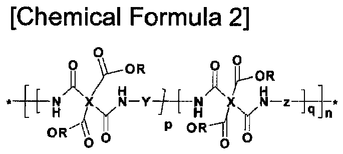 wherein X is a quadrivalent organic group, Y is a bivalent organic group, and Z is derived from a diamine compound expressed by Chemical Formula 3 shown below: 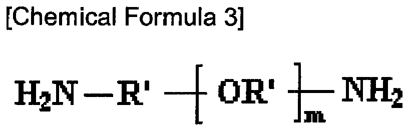 wherein m is an integer ranging from 2 to 21, and R' is an alkylene group having 2 to 6 carbon atoms, 0≤p<1, 0<q≤1, p+q=1, n is an integer ranging from 2 to 500, and R is selected from the group consisting of hydrogen, an alkyl group, and a silyl alkyl group.

2. The composition of claim 1, wherein Z is derived from a diamine compound expressed by Chemical Formula 4 shown below: 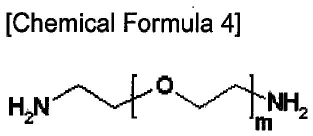 wherein m is an integer ranging from 2 to 21.

3. The composition of claim 2, wherein m in Chemical Formula 4 is an integer ranging from 2 to 7.

4. The composition of claim 1, wherein a substituent X in Chemical Formula 1 or 2 is one or more selected from the group consisting of organic groups expressed by chemical formulas shown below:

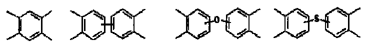

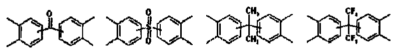

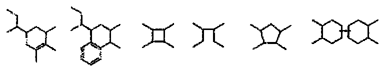

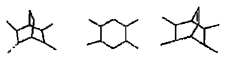

5. The composition of claim 1, wherein a substituent Y in Chemical Formula 1 or 2 is one or more selected from the group consisting of organic groups expressed by chemical formulas shown below:

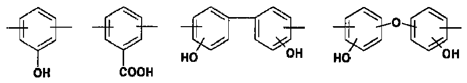

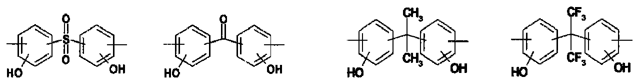

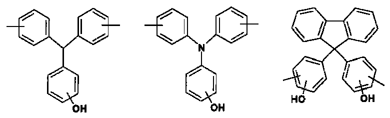

6. The composition of claim 1, wherein the substituent Y in Chemical Formula 1 or 2 is an organic group derived from one or more diamine compound groups expressed by chemical formulas shown below:

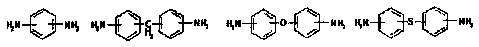

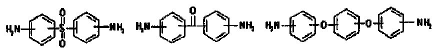

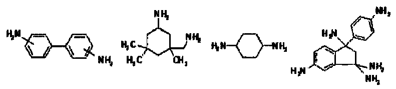

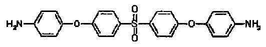

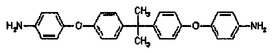

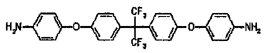

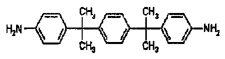

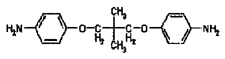

7. The composition of claim 1, wherein the photo active compound is one or more selected from the group consisting of compounds expressed by chemical formulas shown below: 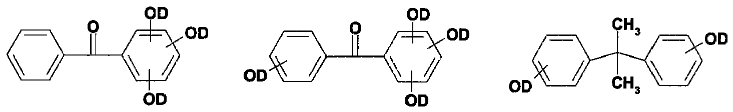 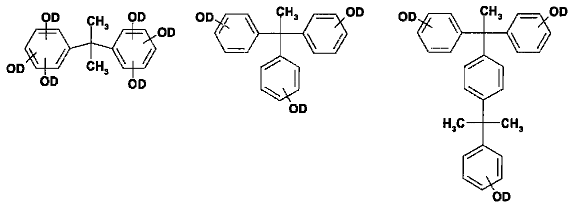 wherein D is one or more selected from among organic groups expressed by chemical formulas shown below and a hydrogen atom (-H):

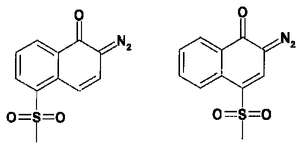

8. The composition of claim 1, wherein, 0.1 to 30 weight parts of one or more additives selected from the group consisting of a dissolution speed regulator, a sensitizer, an adhesion promoter, and a surfactant is contained over 100 weight parts of the polyimide or the precursor thereof.

9. The composition of claim 1, wherein 40 to 97 weight part of one or more solvents selected from the group consisting of N-methyl-2-pyrrolidone, N,N-dimethylformamide, N,N-dmiethylacetamide, dimethylsulfoxide, N,N-diethylacetamide, γ-butyrolactone, γ-valerolactone, m-cresol, ethyleneglycol monomethylether, ethyleneglycol monomethylether acetate, ethyleneglycol monoethylether, ethyleneglycol monoethylether acetate, ethyleneglycol monobutylether, ethyleneglycol monobutylether acetate, propyleneglycol monomethylether, propyleneglycol monomethylether acetate, propyleneglycol monoethylether, propyleneglycol monoethylether acetate, propyleneglycol monopropylether, propyleneglycol monopropylether acetate, propyleneglycol monobutylether, propyleneglycol monobutylether acetate, propyleneglycol dimethylether, propyleneglycol diethylether, propyleneglycol dipropyltylether, propyleneglycol dibutylether, ethyl lactate, butyl lactate, cyclohexanone, and cyclopentanone is contained over 100 weight parts of the composition.

10. An organic light emitting diode (OLED) insulating layer, a liquid crystal display (LCD) insulating layer, or a semiconductor insulating layer comprising a polyimide film prepared with the photosensitive resin composition according to claim 1.
